# EUROPÄISCHE PATENTANMELDUNG

(11) **EP 0 675 546 A2**
(43) Veröffentlichungstag der Anmeldung: **04.10.1995**
(21) Anmeldenummer: 95102892.7
(22) Anmeldetag: 01.03.1995
(51) Int. Cl.: H01L 29/78, H01L 29/423, H01L 21/335

(54) **Verfahren zur Herstellung eines Einzelelektronen-Bauelementes**

(30) Priorität: 22.03.1994 DE 4409863
(71) Anmelder: SIEMENS AKTIENGESELLSCHAFT, D-80333 München (DE)
(72) Erfinder: Rösner, Wolfgang, Dr., D-81739 München (DE); Vogelsang, Thomas, Dr., Essex Junction, VT 05452 (US)

(57) **Zusammenfassung**

Zur Herstellung eines Einzelelektroden-Bauelementes in MOS-Technik wird in einem Siliziumsubstrat (14) ein aktives Gebiet definiert, das mit einem Gatedielektrikum (16) versehen wird. Mit Hilfe eines Feinstrukturierungsverfahrens, insbesondere mit Elektronenstrahl-Lithographie, wird eine erste Gateebene (12) mit feinen Strukturen < 100 nm erzeugt, deren Oberfläche und Flanken mit einer isolierenden Schicht (17, 17a) bedeckt werden. Es wird eine zweite Gateebene (13) erzeugt, die die feinen Strukturen der ersten Gateebene (12) mindestens im Bereich des aktiven Gebietes überdeckt.

## Beschreibung

In der Technologie integrierter Schaltungen ist das Interesse auf höhere Integrationsdichten und/oder höhere Schaltgeschwindigkeiten gerichtet. Neben einer Weiterentwicklung der herkömmlichen CMOS-Technik in diese Richtung werden zunehmend andere Bauelemente vorgeschlagen, mit denen dieses Ziel möglicherweise zweckmäßiger erreicht werden kann. Als besonders erfolgsversprechend werden dabei sogenannte Einzelelektronen-Bauelemente angesehen, die mit der sogenannten Coulomb-Blockade arbeiten. Ein Überblick über derartige Einzelelektronen-Bauelemente ist zum Beispiel dem Aufsatz A. Gladun et al, Physik in unserer Zeit 23 (1992) Seite 159, zu entnehmen.

Derartige Einzelelektronen-Bauelemente weisen einen oder mehrere Knoten auf, die nur über hochohmige Potentialbarrieren umgeladen werden können. Diese Umladung kann durch den quantenmechanischen Tunneleffekt oder durch thermisch aktivierten Ladungsübertritt bewirkt werden.

Die Umladung eines Knotens mit einer Gesamtkapazität C um eine Elementarladung e entspricht einem Ladungstransport von einem Elektron über die Potentialbarriere. Um den Knoten um eine Elementarladung e umzuladen, ist ein Energieaufwand in dem Größenordnung e²/C erforderlich. Ist die thermische Energie k_{B}T (k_{B}: Boltzmannkonstante, T: absolute Temperatur) des Systems sehr viel kleiner als dieser Energieaufwand, das heißt k_{B}T << e²/C, so ist dieser Ladungsübertritt verboten. Nur durch Anlegen einer hinreichend großen äußeren Spannung ist ein Ladungsübertritt möglich.

Aus k_{B}T << e²/C ergibt sich eine Abschätzung für die Gesamtkapazität des Systems. Bei der Temperatur von flüssigem Helium, T = 4.2 K, ergibt sich C << 4 . 10⁻¹⁶F = 0.4 fF. Einzelelektronen-Bauelemente, die bei Raumtemperatur betrieben werden können, müssen eine noch kleinere Kapazität aufweisen. Für Raumtemperatur T = 300 K ergibt sich C << 6 . 10⁻¹⁸F = 6 aF.

Es sind verschiedene Bauelemente vorgeschlagen worden, die diesen Effekt ausnutzen: Single Electron Transistor, Turnstile Device, Electron Pump, Single Electron Memory.

Ob diese Bauelemente im großtechnischen Maßstab Bedeutung erlangen werden, hängt davon ab, ob das Problem der Herstellung derartig kleiner Kapazitäten mit geeigneten Potentialbarrieren befriedigend gelöst wird.

Es ist vorgeschlagen worden (siehe zum Beispiel P. Lafarge et al, Z. Phys. B 85 (1991) Seite 327, zur Herstellung von Einzelelektronen-Bauelementen Aluminium-Streifenleitungen mit möglichst kleinen Abmessungen zu verwenden. Sie wurden mit Elektronenstrahl-Lithographie strukturiert. Als Potentialbarrieren werden Tunnelbarrieren aus AlₓO_{y} verwendet, die zwischen zwei sich überlappenden Streifenleitungen angeordnet sind. Derartige Tunnelbarrieren weisen Kapazitäten um 10⁻¹⁵ F = 1fF auf, so daß diese Bauelemente bei Temperaturen um T = 20 mK betrieben werden müssen.

Ein anderer Vorschlag besteht darin, ein zweidimensionales Elektronengas (2DEG) in Galliumarsenid, entweder durch eine Deltadotierung oder eine Heterostruktur zu erzeugen. Zur lateralen Strukturierung wird wiederum Elektronenstrahl-Lithographie eingesetzt. Auf diese Weise können Kapazitäten von 2 . 10¹⁷F ...2 . 10⁻¹⁶ F = 20 ... 200 aF erzielt werden. Dabei ist vorgeschlagen worden, durch Verwendung eines Gates das zweidimensionale Elektronengas lokal zu verarmen und so die Potentialbarriere zu realisieren. Die Höhe der Potentialbarriere kann dabei durch äußere Spannungen eingestellt werden.

Aus H. Matsuoka et al, IEDM 92 Seite 781, ist ein Bauelement in Silizium-MOS-Technik bekannt, in dem Einzelelektroneffekte beobachtet wurden. Das Bauelement umfaßt einen MOS-Transistor mit einer ersten Gateelektrode, deren Länge zwischen Source und Drain etwa 5 µm und deren Breite senkrecht dazu 0,13 µm beträgt. Dieser MOS-Transistor weist daher eine sehr geringe Weite auf. In einer zweiten Ebene ist eine zweite Gateelektrode angeordnet, die quer über die erste Gateelektrode verlaufende Stege aufweist, die jeweils eine Breite von 0,14 µm und einen gegenseitigen Abstand von 0,16 µm aufweisen. Durch Anlegen einer entsprechenden Steuerspannung an die zweite Gateelektrode kann durch seitliche Feldeinwirkung der Transistorkanal abgeschnürt werden. Gemessene Kennlinien werden dabei so gedeutet, daß beim Abschnüren eine Reihe von Knoten entstehen, die jeweils über Potentialbarrieren voneinander getrennt sind, und daß Coulomb-Blockade auftritt. Die erste und die zweite Gateelektrode in dieser Anordnung werden durch Elektronenstrahl-Lithographie strukturiert. Es muß dabei eine Justierung der zweiten Elektronenstrahl-Lithographie auf die erste Elektronenstrahl-Lithographie erfolgen, die mit erhöhtem Prozeßaufwand verbunden ist.

Der Erfindung liegt das Problem zugrunde, ein Verfahren zur Herstellung eines Einzelelektronen-Bauelementes anzugeben, in dem das Einzelelektronen-Bauelement in Silizium-MOS-Technik mit mindestens zwei Gateebenen hergestellt wird wobei die beiden Gateebenen zueinander selbstjustiert hergestellt werden.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird die Oberfläche eines aktiven Gebietes in einem Siliziumsubstrat mit einem Gatedielektrikum versehen. Darauf wird mit Hilfe eines Feinstrukturierungsverfahrens eine erste Gateebene erzeugt, die feine Strukturen mit in einer Ausdehnung Abmessungen < 100 nm aufweist. Als Feinstrukturierungsverfahren ist jedes Verfahren geeignet, das Strukturen mit Abmessungen unter 100 nm herstellen kann. Vorzugsweise wird als Feinstrukturierungsverfahren Elektronenstrahl-Lithographie eingesetzt. Zum Erreichen extrem kleiner Abmessungen im Bereich 10 nm ist es vorteilhaft, den Elektronenstrahl für die Elektronenstrahl-Lithographie mit Hilfe eines Rastertunnelmikroskops zu erzeugen.

Die erste Gateebene wird so strukturiert, daß es Bereiche gibt, in denen die Oberfläche des Gatedielektrikums freigelegt ist.

Oberfläche und Flanken der ersten Gateebene werden mit einer isolierenden Schicht versehen. Anschließend wird eine zweite Gateebene erzeugt, die die feinen Strukturen der ersten Gateebene mindestens im Bereich des aktiven Gebietes überdeckt.

Es liegt im Rahmen der Erfindung, daß die feinen Strukturen der ersten Gateebene in zwei Ausdehnungen Abmessungen < 100 nm aufweisen. Das heißt, die feinen Strukturen umfassen Flächenelemente mit Seitenlängen jeweils < 100 nm. In diesem Fall ist nur zur Strukturierung der ersten Gateebene ein Feinstrukturierungsverfajren, insbesondere Elektronenstrahl-Lithographie erforderlich. Die zweite Gateebene und das aktive Gebiet können mit Hilfe konventioneller Lithographie erzeugt werden Ort und Abmessungen von Knoten bzw. Potentialbarrieren des Einzelelektronen-Bauelementes werden durch die feinen Strukturen der ersten Gateebene definiert.

Gemäß einer weiteren Ausführungsform der Erfindung wird zur Definition des aktiven Gebietes auf das Substrat eine isolierende Schicht aufgebracht. Die isolierende Schicht wird mit Hilfe eines Feinstrukturierungsverfahrens, insbesondere Elektronenstrahl-Lithographie, so strukturiert, daß im Bereich des aktiven Gebietes die Oberfläche des Siliziumsubstrates freigelegt wird. Das aktive Gebiet wird in einer solchen Form erzeugt, daß es mindestens teilweise einen streifenförmigen Querschnitt aufweist. Die Breite des Streifens beträgt dabei < 100 nm.

Die erste Gateebene wird in dieser Ausführungsform so erzeugt, daß sie streifenförmige Strukturen umfaßt, die quer zu dem streifenförmigen Querschnitt des aktiven Gebietes verlaufen. Auch die streifenförmigen Strukturen weisen in einer Dimension eine Breite < 100 nm auf.

Auf diese Weise wird ein Einzelelektronen-Bauelement hergestellt, bei dem Knoten und Potentialbarrieren durch die Kreuzungspunkte zwischen den streifenförmigen Strukturen der ersten Gateebene und dem streifenförmigen Querschnitt des aktiven Gebietes festgelegt werden. Die streifenförmigen Strukturen der ersten Gateebene werden dabei sowohl durch erhabene Strukturen aus leitfähigem Material, die als Gateelektrode wirken, als auch durch Abstände zwischen erhabenen Strukturen realisiert werden.

Gemäß einer Variante dieser Ausführungsform wird die erste Gateebene so strukturiert, daß sie zwei voneinander elektrisch getrennte Gateelektroden umfaßt. Beide Gateelektroden enthalten eine quer zum streifenförmigen Querschnitt des aktiven Gebietes verlaufende streifenförmige Struktur, deren Breite jeweils < 100 nm ist und die im wesentlichen parallel zueinander mit einem Abstand < 100 nm angeordnet sind. In einem nach dieser Ausführungsform hergestellten Einzelelektronen-Bauelement wird an die zweite Gateebene eine solche Spannung angelegt, daß sich außerhalb der ersten Gateebene im aktiven Gebiet Inversionsgebiete bilden. Es bilden sich drei Inversionsgebiete, zwei jeweils außerhalb der beiden Gateelektroden der ersten Gateebene und eines zwischen den beiden Gateelektroden. Über die beiden Gateelektroden der ersten Gateebene werden Potentialbarrieren zwischen jeweils benachbarten Inversionsschichten angesteuert. Da die beiden Gateelektroden elektrisch getrennt sind, lassen sich die Potentialbarrieren einzeln ansteuern.

Gemäß einer weiteren Variante dieser Ausführungsform wird die erste Gateebene so hergestellt, daß sie drei elektrisch voneinander getrennte Gateelektroden umfaßt. Eine mittlere Gateelektrode umfaßt dabei eine streifenförmige Struktur, die quer zum streifenförmigen Querschnitt des aktiven Gebietes verläuft und deren Breite < 100 nm ist. Zwei seitliche Gateelektroden sind jeweils auf gegenüberliegenden Seiten der streifenförmigen Struktur der mittleren Gateelektrode in einem Abstand von jeweils < 100 nm angeordnet. Der streifenförmige Querschnitt des aktiven Gebietes erstreckt sich bis in den Bereich der seitlichen Gateelektroden der ersten Gateebene. In einem nach dieser Ausführungsform hergestellten Einzelelektronen-Bauelement wird die Höhe von zwei Potentialbarrieren durch eine an der zweiten Gateebene angelegte Spannung fest vorgegeben. Durch die beiden seitlichen Gateelektroden der ersten Gateebene werden Inversionsschichten eingestellt. Über die mittlere Gateelektrode der ersten Gateebene wird zwischen den beiden Potentialbarrieren eine weitere Inversionsschicht eingestellt. Durch leichte Spannungsänderungen an der mittleren Gateelektrode läßt sich in diesem Einzelelektronen-Bauelement der Potentialverlauf so beeinflussen, daß es zu einer Umladung des Knotens, der durch die unter der mittleren Gateelektrode angeordnete Inversionsschicht gebildet wird, kommt.

Vorzugsweise wird die isolierende Schicht, die zur Definition des aktiven Gebietes verwendet wird, aus SiO₂ durch thermische Zersetzung von Si(OC₂H₅)₄ (TEOS) gebildet. Die erste Gateebene wird durch Abscheidung und Strukturierung einer ersten dotierten Siliziumschicht, die zweite Gateebene durch Abscheidung und Strukturierung einer zweiten dotierten Siliziumschicht gebildet. Vorzugsweise wird die dotierte Siliziumschicht im Temperaturbereich (555 ... 565)°C amorph abgeschieden, wobei dem Prozeßgas Dotierstoff zugegeben wird. Durch Abscheidung als amorphe Schicht wird sichergestellt, daß auch schmale Gräben in der jeweiligen Oberflache aufgefüllt werden. Das aktive Gebiet wird mit zwei Anschlußbereichen versehen, die außerhalb der ersten Gateebene und der zweiten Gateebene angeordnet sind. Die Anschlußbereiche werden so angeordnet, daß ein Strom durch das aktive Gebiet zwischen den beiden Anschlußbereichen durch die erste Gateebene bzw. zweite Gateebene gesteuert wird. Vorzugsweise werden die Anschlußbereiche durch Implantation im Siliziumsubstrat gebildet.

Im folgenden wird die Erfindung anhand der Figuren und der Ausführungsbeispiele näher erläutert.
- Figur 1: zeigt einen Schnitt durch ein erfindungsgemäß hergestelltes Einzelelektronen-Bauelement.
- Figur 2: zeigt den Potentialverlauf in dem in Figur 1 dargestellten Einzelelektroden-Bauelement.
- Figur 3: zeigt ein Layout eines erfindungsgemäß hergestellten Einzelelektronen-Bauelementes.
- Figur 4: zeigt einen Schnitt durch ein Siliziumsubstrat mit einer ein aktives Gebiet definierenden, strukturierten isolierenden Schicht, einem Gatedielektrikum, einer ersten Gateebene und einer SiO₂-Schicht.
- Figur 5: zeigt den in Figur 4 mit V-V bezeichneten Schnitt.
- Figur 6: zeigt das Siliziumsubstrat nach Bildung von SiO₂-Spacern an senkrechten Flanken der ersten Gateebene und nach Erzeugung der zweiten Gateebene.
- Figur 7: zeigt den in Figur 6 mit VII-VII bezeichneten Schnitt.
- Figur 8: zeigt ein Layout einer zweiten Ausführungsform eines erfindungsgemäß hergestellten Einzelelektronen-Bauelementes.
- Figur 9: zeigt ein Layout einer dritten Ausführungsform eines erfindungsgemäß hergestellten Einzelelektronen-Bauelementes.

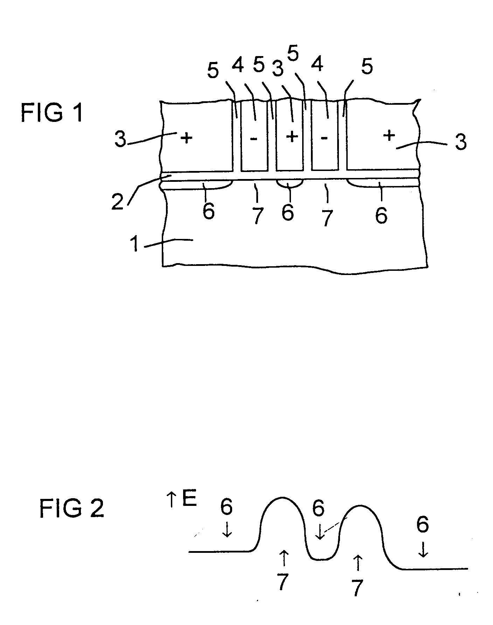

Auf ein Siliziumsubstrat 1, das zum Beispiel p-dotiert ist mit einer Dotierstoffkonzentration von zum Beispiel 10¹⁵ cm⁻³ , wird eine Gateoxidschicht 2 aufgebracht (siehe Figur 1). Es wird eine erste Gateebene 3 und eine zweite Gateebene 4 erzeugt, die jeweils aus dotiertem amorphem oder polykristallinem Silizium bestehen. Die erste Gateebene 3 umfaßt drei Gateelektroden, die zweite Gateebene 4 umfaßt zwei Gateelektroden. Die einzelnen Cateelektroden sind seitlich durch Isolationsstege 5 gegeneinander isoliert.

Anhand von Figur 1 und Figur 2 wird zunächst die Funktionsweise eines nach dem erfindungsgemäßen Verfahren herzustellenden Bauelementes erläutert.

Durch Anlegen einer positiven Spannung an die Gateelektroden der ersten Gateebene 3 bilden sich an der Oberfläche des Siliziumsubstrats 1 Inversionsschichten 6. Die laterale Ausdehnung der Inversionsschichten 6 ist durch die Geometrie der Elektroden der ersten Gateebene 3 gegeben. Die Inversionsschicht 6, die der mittleren Gateelektrode der ersten Gateebene 3 zugeordnet ist, weist zum Beispiel im wesentlichen kreisförmigen Querschnitt auf mit einem Durchmesser von 20 nm und besitzt eine Gesamtkapazität von 10 aF. Der Abstand zwischen der mittleren Gateelektrode und den seitlichen Gateelektroden der ersten Gateebene 3 beträgt zum Beispiel etwa 40 nm. In diesem Bereich sind jeweils die Gateelektroden der zweiten Gateebene 4 angeordnet.

Wird an die Gateelektroden der zweiten Gateebene eine negative Spannung angelegt, so bilden sich zwischen benachbarten Inversionsschichten 6 im Siliziumsubstrat Potentialbarrieren 7.

In Figur 2 ist der Potentialverlauf in dem in Figur 1 dargestellten Bauelement skizziert. Das Potential E = - e . Oberflächenpotential. Durch Pfeile sind in den Potentialverlauf die Orte der Inversionsschichten 6 sowie der Potentialbarrieren 7 eingetragen. Die Potentialbarrieren 7 verhindern einen freien Elektronenfluß durch das Einzelelektronen-Bauelement. Die mittlere Inversionsschicht 6 stellt einen Potentialtopf dar, in dem ein Elektron gespeichert werden kann. Durch Variation der Höhe der Potentialbarrieren 7 oder der Tiefe des Potentialtopfes der mittleren Inversionsschicht 6 durch Ansteuerung von außen kann ein Elektronenfluß durch das Bauelement erfolgen. Ein solches Bauelement wird in der Literatur als Einzelelektron-Transistor, Single Electron Transistor, SET bezeichnet. Dieses Bauelement kann bei einer Temperatur von 4 K betrieben werden.

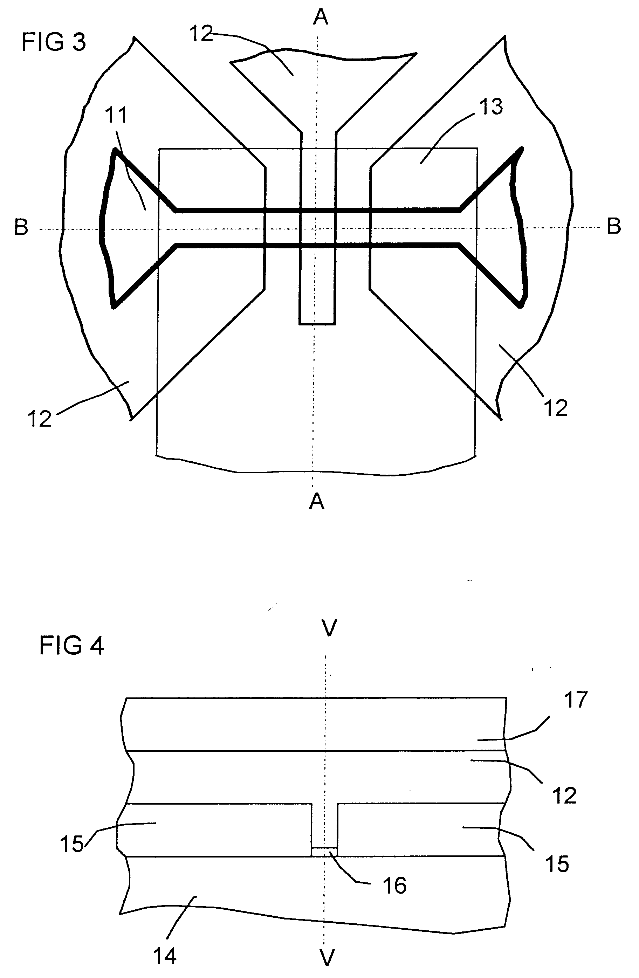

Figur 3 zeigt ein Layout eines erfindungsgemäß hergestellten Einzelelektronen-Bauelementes. Ein aktives Gebiet 11 weist mindestens teilweise einen streifenförmigen Querschnitt auf, der in einer Dimension eine Breite < 100 nm, vorzugsweise 30 nm aufweist. Oberhalb des aktiven Gebietes 11 ist eine erste Gateebene 12 angeordnet, die drei Gateelektroden umfaßt. Eine mittlere Cateelektrode der ersten Gateebene 12 umfaßt eine streifenförmige Struktur, die den streifenförmigen Querschnitt des aktiven Gebietes 11 kreuzt. Die streienförmige Struktur weist eine Breite von < 100 nm, vorzugsweise 30 nm auf. Ferner umfaßt die erste Cateebene 12 zwei äußere Gateelektroden, die mit einer im wesentlichen geraden Flanke den streifenförmigen Querschnitt des aktiven Gebietes kreuzen und zwischen deren im wesentlichen gerader Flanke und der mittleren Gateelektrode ein Abstand < 100 nm, vorzugsweise 30 nm besteht.

Nach außen hin weitet sich sowohl das aktive Gebiet 11 als auch die Gateelektroden der ersten Gateebene 12 auf. Die beiden äußeren Gateelektroden der ersten Gateebene 12 überdecken das aktive Gebiet 11 am Rand dessen streifenförmigen Querschnitts. Außerhalb der Figur 3 überragt das aktive Gebiet 11 jedoch die erste Gateebene 12 seitlich und ist beiderseits mit hochdotierten Anschlußgebieten versehen. Oberhalb der ersten Gateebene 12 ist eine zweite Gateebene 13 angeordnet. Die zweite Gateebene 13 überdeckt mindestens den streifenförmigen Querschnitt des aktiven Gebietes sowie die Kreuzungspunkte der feinen Strukturen der ersten Gateebene 12 mit dem aktiven Gebiet 11.

In diesem Einzelelektronen-Bauelement werden Inversionsgebiete durch entsprechende Spannungen an der ersten Gateebene 12 gebildet. Potentialbarrieren werden durch entsprechende Spannungen an der zweiten Gateebene 13 eingestellt.

Zur Herstellung des anhand von Figur 3 erläuterten Einzelelektronen-Bauelementes wird auf ein Siliziumsubstrat 14 eine isolierende Schicht 15 aus SiO₂ aufgebracht (siehe Figur 4). Die isolierende Schicht 15 wird vorzugsweise durch thermische Zersetzung von Si(OC₂H₅)₄ (TEOS) in einer Dicke von 100 nm hergestellt.

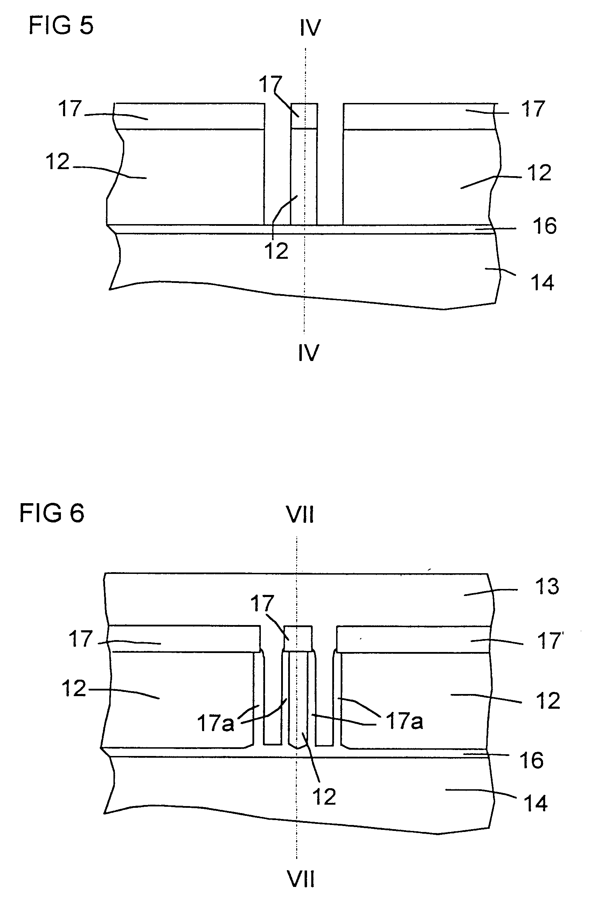

Mit Hilfe von Elektronenstrahl-Lithographie wird die isolierende Schicht 15 strukturiert. Dabei wird die Oberfläche des Siliziumsubstrats 14 freigelegt. Die strukturierte isolierende Schicht 15 definiert auf der Oberflache des Siliziumsubstrates 14 das aktive Gebiet 11. Figur 4 zeigt den in Figur 3 mit A-A bezeichneten Schnitt. Figur 5 zeigt den in Figur 3 mit B-B bezeichneten Schnitt.

Zur Strukturierung der isolierenden Schicht 15 wird nach der Elektronenstrahl-Lithographie ein anisotroper Ätzprozeß mit zum Beispiel CHF₃, O₂ durchgeführt. Anschließend wird bei der Elektronenstrahl-Lithographie verwendete Lack entfernt.

Durch eine trockene thermische Oxidation wird ein Gateoxid 16 in einer Dicke von zum Beispiel 16 nm auf der freiliegenden Oberfläche des Siliziumsubstrats 14 erzeugt.

Es wird ganzflächig eine erste dotierte Siliziumschicht in einer Dicke von zum Beispiel 100 nm abgeschieden und durch Phosphordiffusion mit POCl n-dotiert. Die dotierte Polysiliziumschicht füllt einen Graben in der isolierenden Schicht 15, der durch den streifenförmigen Querschnitt des aktiven Gebietes 11 bewirkt wird, vollständig auf.

Nach Entfernen von bei der Phosphordiffusion abgeschiedenen SiO₂ durch naßchemisches Ätzen von 100 nm SiO₂ wird ganzflächig eine SiO₂-Schicht 17 aufgebracht. Die SiO₂-Schicht 17 wird zum Beispiel durch thermische Zersetzung von TEOS in einer Dicke von 100 nm aufgebracht.

Mit Hilfe von Elektronenstrahl-Lithographie werden anschließend die SiO₂-Schicht 17 und die dotierte Polysiliziumschicht strukturiert, wobei aus der dotierten Polysiliziumschicht die erste Cateebene 12 entsteht. Bei der Strukturierung der dotierten Polysiliziumschicht wird die SiO₂-Schicht 17 oberhalb des aktiven Gebietes gedünnt, wie Figur 5 zu entnehmen ist. Die SiO₂-Schicht 17 und die dotierte Polysiliziumschicht werden jeweils durch anisotropes Ätzen strukturiert. Die Ätzung der SiO₂-Schicht 17 erfolgt mit CHF₃, O₂ . Vor der Ätzung der dotierten Polysiliziumschicht wird bei der Elektronenstrahl-Lithographie verwendeter Lack entfernt. Zur Ätzung der Polysiliziumschicht mit zum Beispiel HBr, Cl₂ wird die strukturierte SiO₂-Schicht 17 als Maske verwendet.

In Figur 4 ist durch die gestrichelte Linie V-V der in Figur 5 dargestellte Schnitt bezeichnet. In Figur 5 ist durch die gestrichelte Linie IV-IV der in Figur 4 gezeigte Schnitt bezeichnet.

Anschließend werden an freiliegenden Flanken der ersten Gateebene 12 SiO₂-Spacer erzeugt. Dieses erfolgt zum Beispiel durch eine trockene thermische Oxidation in einer Dicke von 16 nm oder durch CVD-Abscheidung einer SiO₂-Schicht und anschließend anisotropes Rückätzen (siehe Figur 6).

Anschließend wird zur Bildung der zweiten Gateebene 13 eine zweite Polysiliziumschicht in einer Dicke von zum Beispiel 100 nm abgeschieden. Mit Hilfe konventioneller Photolithographie und anisotropem Ätzen wird die zweite Polysiliziumschicht strukturiert, wobei die zweite Gateebene 13 entsteht. Die zweite dotierte Polysiliziumschicht muß so abgeschieden werden, daß sie die Graben, die durch die Abstände zwischen der mittleren Gateelektrode und den äußeren Gateelektroden der ersten Gateebene 12 entstehen (siehe Figur 3) vollständig auffüllt. Nach Entfernen des Photolacks der bei der Photolithographie verwendet wurde, wird durch Implantation von Arsen mit einer Implantationsenergie von 50 keV und bei einer Teilchendichte von 5 . 10¹⁵ cm⁻² die zweite Gateebene 13 n-dotiert. Der Dotierstoff wird bei einer Temperung in Inertgas bei 900°C aktiviert.

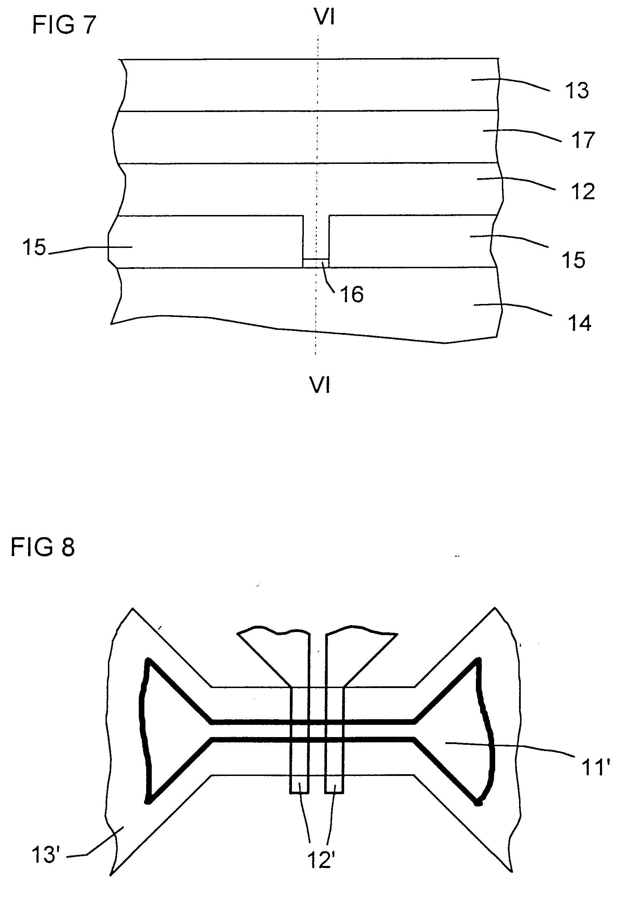

In Figur 6 ist mit VII-VII der in Figur 7 gezeigte Schnitt, der dem mit A-A in Figur 3 bezeichneten Schnitt entspricht, eingezeichnet. In Figur 7 ist mit VI-VI der in Figur 6 dargestellte Schnitt, der dem in Figur 3 mit B-B bezeichneten Schnitt entspricht, eingetragen. Zur Fertigstellung des Bauelementes wird anschließend ein Zwischenoxid abgeschieden, in dem Kontaktlöcher geöffnet und mit Metallisierungen versehen werden. Diese Verfahrensschritte sind nicht dargestellt.

Figur 8 zeigt das Layout eines weiteren Bauelementes, das in dem erfindungsgemäßen Verfahren herstellbar ist. Ein aktives Gebiet 11' weist mindestens teilweise einen streifenförmigen Querschnitt auf, der in einer Dimension eine Breite < 100 nm, vorzugsweise 30 nm , hat. Eine darüber angeordnete erste Gateebene 12' umfaßt zwei Gateelektroden, die jeweils eine streifenförmige Struktur enthalten. Die streifenförmigen Strukturen der beiden Gateelektroden weisen in einer Dimension jeweils Breiten < 100 nm, vorzugsweise 30 nm auf. Die Gateelektroden der ersten Gateebene 12' sind so angeordnet, daß die streifenförmigen Strukturen den streifenförmigen Querschnitt des aktiven Gebietes 11' kreuzen. Oberhalb der ersten Gateebene 12' ist eine zweite Gateebene 13' angeordnet, die mindestens den streifenförmigen Querschnitt des aktiven Gebietes 11' überdeckt.

In diesem Einzelelektronen-Bauelement werden Inversionsschichten im aktiven Gebiet durch Anlegen einer Spannung an die zweite Gateebene 13' erzeugt. Durch Anlegen von Spannungen an die Cateelektroden der ersten Gateebene 12' wird die Hohe von Potentialbarrieren, die unter den Gateelektroden der ersten Gateebene 12' angeordnet sind, gesteuert.

Zur Herstellung dieses Einzelelektronen-Bauelementes werden bei der Bildung des aktiven Gebietes 11' sowie der ersten Gateebene 12' jeweils Elektronenstrahl-Lithographie benötigt. Die zweite Gateebene 13' wird mit konventioneller Photolithographie hergestellt. Sie wird selbstjustiert zur ersten Gateebene 12' erzeugt.

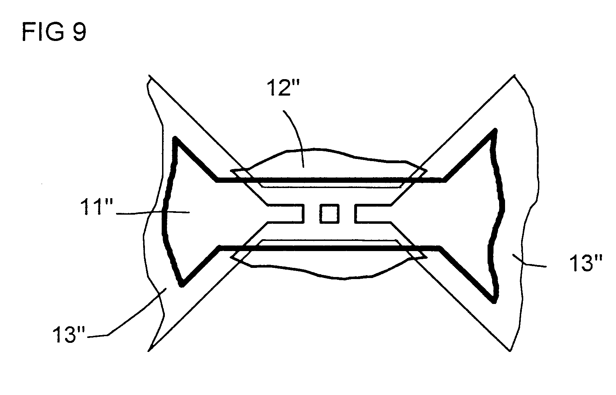

Figur 9 zeigt ein Layout eines weiteren Einzelelektronen-Bauelementes, das nach dem erfindungsgemäßen Verfahren herstellbar ist. Zur Herstellung dieses Einzelelektronen-Bauelementes ist nur bei der Strukturierung einer ersten Gateebene 12'' ein Feinstrukturierungsverfahren, insbesondere Elektronenstrahllithographie, erforderlich. Aktives Gebiet 11'' sowie zweite Gateebene 13'' können mit Abmessungen, die durch konventionelle Photolithographie erreichbar sind, hergestellt werden. Die erste Gateebene 12'' umfaßt zwei Hauptteile, die mit im wesentlichen geraden Flanken benachbart mit einem Abstand < 100 nm, vorzugsweise 30 nm , zueinander angeordnet sind. Die beiden Hauptteile sind über zwei Stege miteinander verbunden. Die beiden Stege weisen parallel zu den im wesentlichen geraden Flanken der beiden Hauptteile Abmessungen von jeweils < 100 nm, vorzugsweise 30 nm auf. Untereinander weisen die beiden Stege einen Abstand von wiederum < 100 nm, vorzugsweise 30 nm auf.

Das aktive Gebiet 11'' und die zweite Gateebene 13'' sind so angeordnet, daß sie jeweils die im wesentlichen geraden Flanken der beiden Hauptelemente sowie die Stege der ersten Gateebene 12'' sicher überdecken.

In diesem Einzelelektronen-Bauelement werden Inversionsschichten durch Anlegen einer Spannung an die zweite Gateebene 13'' im aktiven Gebiet erzeugt. Potentialbarrieren werden unter der ersten Gateebene 12'' durch Anlegen einer entsprechenden Spannung eingestellt. Zur Herstellung dieses Einzelelektronen-Bauelementes ist nur ein Elektronenstrahl-Lithographieschritt erforderlich. Diese Prozeßvereinfachung wird damit erkauft, daß die beiden Potentialbarrieren nur gemeinsam angesteuert werden können.

Da in den Einzelelektronen-Bauelementen, die anhand von Figur 3 sowie Figur 8 erläutert wurden, die erste Gateebene 12, 12' jeweils elektrisch getrennte Gateelektroden umfaßt, können hier die einzelnen Gateelektroden individuell angesteuert werden. Auf diese Weise lassen sich auch kompliziertere Einzelelektronen-Bauelemente aufbauen.

## Patentansprüche

1. Verfahren zur Herstellung eines Einzelelektronen-Bauelementes,
- bei dem in einem Siliziumsubstrat (14) ein aktives Gebiet (11) definiert wird,
- bei dem die Oberfläche des aktiven Gebietes (11) mit einem Catedielektrikum (16) versehen wird,
- bei dem mit Hilfe eines Feinstrukturierungsverfahrens eine erste Gateebene (12) erzeugt wird, die feine Strukturen mit in einer Dimension Abmessungen < 100 nm aufweist,
- bei dem Oberfläche und Flanken der ersten Gateebene (12) mit einer isolierenden Schicht (17, 17a) versehen werden,
- bei dem eine zweite Gateebene (13) erzeugt wird, die die feinen Strukturen der ersten Gateebene mindestens im Bereich des aktiven Gebietes (11) überdeckt.

2. Verfahren nach Anspruch 1,
bei dem die erste Gateebene (12) durch ganzflächige Abscheidung einer leitfähigen Schicht und anschließende Elektronenstrahl-Lithographie und anisotropes Ätzen hergestellt wird.

3. Verfahren nach Anspruch 1 oder 2,
- bei dem zur Definition des aktiven Gebietes (11) auf das Substrat eine isolierende Schicht (15) aufgebracht wird,
- bei dem die isolierende Schicht (15) mit Hilfe eines Feinstrukturierungsverfahrens so strukturiert wird, daß im Bereich des aktiven Gebietes (11) die Oberfläche des Siliziumsubstrats (14) freigelegt wird und das aktive Gebiet (11) mindestens teilweise einen streifenförmigen Querschnitt aufweist, der in einer Dimension eine Breite < 100 nm aufweist,
- bei dem die erste Gateebene (12) so erzeugt wird, daß sie streifenförmige Strukturen umfaßt, die quer zu dem streifenförmigen Querschnitt des aktiven Gebietes (11) verlaufen und die eine Breite < 100 nm aufweisen.

4. Verfahren nach Anspruch 3,
bei dem die isolierende Schicht (15) durch Elektronenstrahl-Lithographie und anisotropes Ätzen strukturiert wird.

5. Verfahren nach Anspruch 3 oder 4,
bei dem die erste Gateebene (12) zwei voneinander elektrisch getrennte Gateelektroden umfaßt, die jeweils eine quer zum streifenförmigen Querschnitt des aktiven Gebietes (11) verlaufende streifenförmige Struktur umfassen, deren Breite jeweils < 100 nm ist und die im wesentlichen parallel zueinander mit einem Abstand < 100 nm angeordnet sind.

6. Verfahren nach Anspruch 3 oder 4,
bei dem die erste Gateebene (12) drei voneinander elektrisch getrennte Gateelektroden umfaßt, von denen eine mittlere Gateelektrode eine quer zum streifenförmigen Querschnitt des aktiven Gebietes (11) verlaufende streifenförmige Struktur mit einer Breite < 100 nm umfaßt und von denen zwei seitliche Gateelektroden auf gegenüberliegenden Seiten der streifenförmigen Struktur in einem Abstand von jeweils < 100 nm angeordnet sind.

7. Verfahren nach Anspruch 1 oder 2,
bei dem die erste Gateebene (12'') Strukturen aufweist, die in zwei Dimensionen parallel zur Oberfläche des aktiven Gebietes (11'') Abmessungen von jeweils < 100 nm aufweisen.

8. Verfahren nach einem der Ansprüche 1 bis 7,
- bei dem zur Definition des aktiven Gebietes (11) eine SiO₂-Schicht durch thermische Zersetzung von Si (OC₂H₅)₄ (TEOS) aufgebracht und strukturiert wird,
- bei dem das Gatedielektrikum (16) durch thermische Oxidation erzeugt wird,
- bei dem die erste Gateebene (12) durch Abscheidung und Strukturierung einer ersten Siliziumschicht gebildet wird,
- bei dem die Oberfläche der ersten Gateebene (12) mit einer SiO₂-Schicht (17) versehen wird,
- bei dem im wesentlichen senkrechte Flanken der ersten Gateebene (12) mit SiO₂-Spacern (17a) versehen werden,
- bei dem die zweite Gateebene (13) durch Abscheidung und Strukturierung einer zweiten dotierten Siliziumschicht gebildet wird.

9. Verfahren nach Anspruch 8,
bei dem die SiO₂-Schicht (15) in einer Dicke zwischen 20 nm und 200 nm , das Gatedielektrikum (16) in einer Dicke zwischen 5 nm und 40 nm , die erste dotierte Siliziumschicht in einer Dicke zwischen 20 nm und 200 nm , die SiO₂-Schicht (17) in einer Dicke zwischen 20 nm und 200 nm , die zweite dotierte Siliziumschicht in einer Dicke zwischen 20 nm und 500 nm abgeschieden werden.

10. Verfahren nach einem der Ansprüche 1 bis 9,
- bei dem das aktive Gebiet (11) mit Anschlußbereichen versehen wird, die außerhalb der ersten Gateebene (12) und der zweiten Gateebene (13) angeordnet sind,
- bei dem die Anschlußbereiche durch Ionenimplantation im Siliziumsubstrat (14) gebildet werden.
